Europäisches Patentamt

European Patent Office

Office européen des brevets

(19)

(11) Veröffentlichungsnummer: **0 343 376**
**B1**

(12) **EUROPÄISCHE PATENTSCHRIFT**

(45) Veröffentlichungstag der Patentschrift:
**27.12.90**

(21) Anmeldenummer: **89107072.4**

(22) Anmeldetag: **19.04.89**

(51) Int. Cl.⁵: **H05K 3/22**

(54) **Verfahren zur Herstellung von hartlotbeschichteten Formteilen für die Reparatur von Leiterbahnunterbrechungen.**

(30) Priorität: **26.05.88 DE 3817902**

(43) Veröffentlichungstag der Anmeldung:
**29.11.89 Patentblatt 89/48**

(45) Bekanntmachung des Hinweises auf die Patenterteilung:
**27.12.90 Patentblatt 90/52**

(84) Benannte Vertragsstaaten:
**AT BE CH DE FR GB IT LI NL**

(56) Entgegenhaltungen:
**DE-A- 2 251 997**

**IBM TECHNICAL DISCLOSURE BULLETIN, Band 14,
Nr. 10, März 1972, Seite 2915, New York, US; F.M.
TAPPEN: "Open conductor repair for glass metal
module"**

(73) Patentinhaber: **Siemens Aktiengesellschaft,
Wittelsbacherplatz 2, D-8000 München 2(DE)**

(72) Erfinder: **Fiedelius, Gerhard, Dipl.-Ing.(FH),
Graf-Rüpp-Strasse 18, D-8137 Berg(DE)**

## Beschreibung

Die Erfindung betrifft ein Verfahren zur Herstellung von hartlotbeschichteten Formteilen für die Reparatur von Leiterbahnunterbrechungen, insbesondere zur Reparatur von mäanderförmigen Leiterbahnen, deren Breite beispielsweise im Bereich von 50 bis 70 µm liegt.

Zur Reparatur von regelmäßig auftretenden Leiterbahnunterbrechungen werden der Leiterbahnstruktur entsprechende Formteile annähernd deckungsgleich zu der Leiterbahn in der Umgebung der Unterbrechung oder Fehlerstelle brückenartig auf die defekte Leiterbahn aufgelegt und beidseitig der Unterbrechung mit der Leiterbahn verbunden. Aus der DE-PS 2 251 997 ist ein Verfahren bekannt, mit dem derartige Formteile, die aus einem hartlotbeschichteten Feinband bestehen verarbeitet werden. Die Druckschrift DE-OS 30 25 875 offenbart eine diesbezügliche Vorrichtung zur Reparatur von Leiterbahnunterbrechungen. Diese Vorrichtung besteht aus einem Elektrodensystem, das mittels Widerstandserwärmung die Verbindung zwischen Formteil und Leiterbahn herstellt. In beiden Druckschriften werden Leiterbahnen und entsprechende Formteile mit einer Breite von ca. 100 bis 150 µm behandelt. Derartige Formteile können aufgrund ihrer relativ großen Dimensionierung mittels eines Stanzwerkzeuges ausgestanzt werden. Dabei liegt durch die Verwendung eines platierten Metallbandes in Anschluß an den Stanzvorgang ein fertig platiertes Formteil vor.

Wird nun durch technischen Fortschritt ein Verkleinern der Leiterbahnen auf beispielsweise 50 bis 70 µm Breite möglich, so wird ein entsprechend kleines Formteil zur Reparatur dieser Leiterbahnen benötigt. An dieser Stelle versagt jedoch die übliche Stanztechnik, bei der ein Formteil mittels eines in der Geometrie gleichen Stanzstempels ausgestanzt wird. Die bei der Herstellung von gedruckten Schaltungen übliche Ätztechnik für die Herstellung von oben beschriebenen Formteilen einzusetzen stößt ebenfalls auf Schwierigkeiten. Ein bereits platiertes Metallband wird von dem Ätzmedium unterschiedlich stark, d.h. in Abhängigkeit vom vorhandenen Material sehr unterschiedlich geätzt. Dies führt zu starken Unterätzungen am Formteil, wenn beispielsweise ein hartlotplatiertes Formteil aus einem hartlotplatierten Kupferband hergestellt wird. Das Ätzmedium greift das Kupferband, das Substrat, viel stärker an, als die Hartlotplatierung. Der Einsatz verschiedener Ätzmedien führte zu keinem befriedigenden Ergebnis.

Der Erfindung liegt die Aufgabe zugrunde, ein Verfahren zur Verfügung zu stellen, mittels dem qualitativ hochwertige Formteile gefertigt werden und die zum Einsatz bei der Reparatur einer Leiterbahnunterbrechung geeignet sind.

Diese Aufgabe wird dadurch gelöst, daß zuerst aus einem Metallband die Formteile herausgeätzt werden und anschließend mittels Sputtern eine Hartlotschicht aufgetragen wird.

Der Erfindung liegt die Erkenntnis zugrunde, daß hartlotbeschichtete Formteile zur Reparatur von Leiterbahnunterbrechungen mittels Ätztechnik in einem ersten Verfahrensschritt nur aus einem noch nicht platierten Metallband herstellbar sind. Zur Vermeidung von starken Unterätzungen werden die Formteile aus dem bloßen Metallband herausgeätzt. Die Beschichtung mit einer Lage Hartlot erfolgt in Anschluß daran durch Besputtern, einem Verfahren der Kathodenzerstäubung. Dies führt zu einem Formteil mit gleichmäßig aufgetragener Hartlotschicht, das keine wesentlichen seitlichen Überhänge der Hartlotschicht oder starke Aushöhlungen am Substrat, dem Metallband, aufweist, und das im übrigen ausreichende elektrische und mechanische Eigenschaften zum Einsatz bei der Reperatur von Leiterbahnunterbrechungen besitzt.

Eine vorteilhafte Ausgestaltung der Erfindung sieht die Erstellung eines Formteil-Nutzens vor, in dem mehrere Formteile enthalten sind. Die Vorteile dieser Verfahrensweise liegen in der Halterung einer Vielzahl von Formteilen innerhalb dieses Formteilnutzens, da ein rahmenförmiges Teil des Metallbandes als Träger nach dem Ätzvorgang erhalten bleibt. Zudem kann der Verfahrensschritt des Sputterns an mehreren Formteilen hintereinander durchgeführt werden.

Um das Formteil den Materialien der Leiterbahnen anzupassen, ist es zweckmäßig ein Metallband aus Kupfer zu verwenden.

Die besten Ergebnisse lassen sich durch den Einsatz eines Silberhartlotes erzielen.

Im folgenden wird anhand von schematischen Zeichnungen ein Ausführungsbeispiel beschrieben.

Fig. 1 zeigt einen Formteilnutzen 2, der aus einem Metallband 5 durch Ätzen erstellt wurde und eine Vielzahl von Formteilen 1 beinhaltet.

Fig. 2 zeigt den Querschnitt eines Formteiles 1 nach dem Herausätzen aus einem bereits platierten Metallband.

Fig. 3 zeigt den Querschnitt eines Formteiles 1 nach dem Herausätzen aus einem nichtplatierten Metallband 5 und anschließendem Besputtern mit einer Hartlotschicht 3.

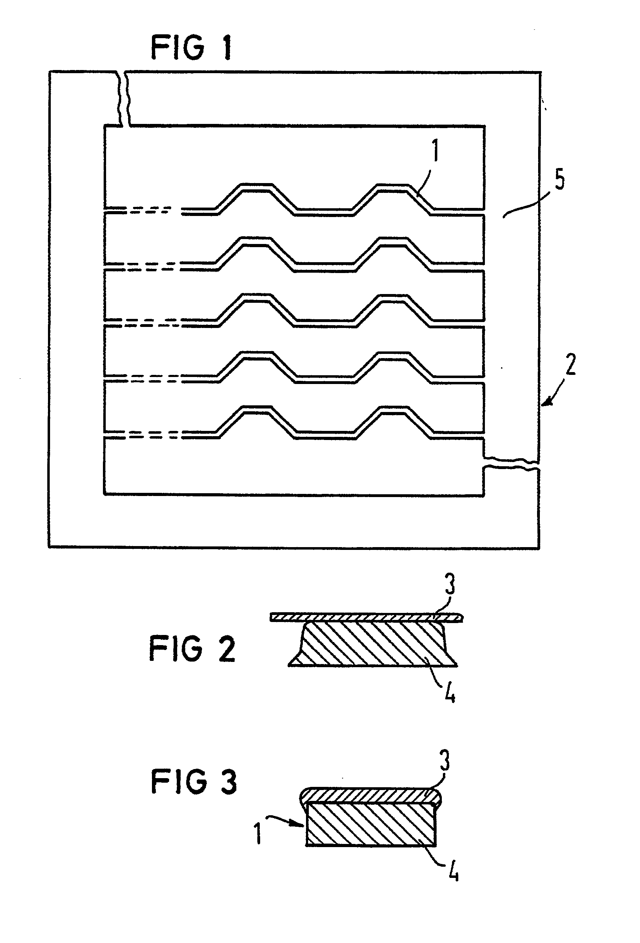

In der Fig. 1 ist ein Formteil-Nutzen 2 dargestellt, der aus einem Metallband 5 hergestellt wurde. Das Metallband besteht nach dem Ätzvorgang noch aus dem stabilen umlaufenden Rahmen und den nach innen stehengebliebenen Formteilen 1. Somit können eine Vielzahl von Formteilen 1 mittels der mechanischen Halterung am verbliebenen Rahmen des Metallbandes 5 gleichzeitig bearbeitet werden. In Anschluß an den Ätzvorgang, der den Formteil-Nutzen 2 wie in der Fig. 1 dargestellt erbringt, werden die Formteile 1 besputtert. Hieraus ist ersichtlich, daß sämtliche herausgeätzten Zwischenräume, sowie der stehengebliebene Rahmen nicht mit einer Hartlotschicht versehen werden müssen, was unter anderem zu einer Materialeinsparung führt.

In der Fig. 2 ist der Querschnitt eines Formteiles (1) dargestellt, daß aus einem vorher platierten Metallband herausgeätzt wurde. Hier ist die starke Unterätzung deutlich zu sehen. Der unterschiedlich starke Angriff des Ätzmediums auf die verschiedenen Materialien führt zu Überständen der Hartlotschicht 3 und zu ungleichmäßigen Einbuchtungen des Metallbandes 5, hier bezeichnet als Substrat 4.

In der Fig. 3 ist ein nach dem erfindungsgemäßen Verfahren hergestelltes Formteil 1 im Querschnitt dargestellt. Das Formteil 1 besteht aus dem Substrat 4, das ätztechnisch aus dem Metallband 5 erhalten wurde und ist einseitig mit einer Hartlotschicht 3 versehen. Diese Hartlotschicht 3 ist gleichmäßig und mechanisch guthaftend aufgetragen, steht geringfügig zu den Seiten über, weist keinerlei Unebenheiten auf und hat die elektrisch und mechanisch erforderlichen Eigenschaften, die zu einer Reparatur einer Leiterbahnunterbrechung nötig sind. Zur Herstellung einer Hartlotschicht 3 mittels Besputtern eignen sich in besonderer Weise die Hartlote aus AgCu 10, sowie L-Ag 28.

Weitere Vorteile dieses Verfahrens bestehen in der kurzfristig variierbaren Gestaltung der Formteile 1 entsprechend verschiedener Leiterbahngeometrien. Zum Durchführen einer Leiterbahnreparatur werden die Formteile 1 entsprechend überlappend zu der Leiterbahnunterbrechung herausgestanzt und dem Reparaturvorgang zugeführt.

## Patentansprüche

1. Verfahren zur Herstellung von hartlotbeschichteten Formteilen (1) für die Reparatur von Leiterbahnunterbrechungen, insbesondere zur Reparatur von mäanderförmigen Leiterbahnen, dadurch gekennzeichnet,
- daß zuerst die Formteile (1) aus einem Metallband (5) herausgeätzt werden und anschließend
- die Hartlotschicht (3) mittels Sputtern aufgetragen wird.

2. Verfahren nach Anspruch 1, dadurch gekennzeichnet, daß aus dem Metallband (5) ein Formteil-Nutzen (2) mit mehreren Formteilen (1) erstellt wird.

3. Verfahren nach einem der vorhergehenden Ansprüche, dadurch gekennzeichnet, daß ein Metallband (5) aus Kupfer verwendet wird.

4. Verfahren nach einem der vorhergehenden Ansprüche, dadurch gekennzeichnet, daß zur Herstellung der Hartlotschicht (3) ein Silberhartlot aufgetragen wird.

## Claims

1. Method of producing preforms (1) coated with hard solder for repairing interconnect interruptions, particularly for repairing meander-shaped interconnects, characterized in that
- firstly the preforms (1) are etched from a metal band (5), and subsequently
- the hard solder layer (3) is applied by means of sputtering.

2. Method according to Claim 1, characterized in that a preform panel (2) having a plurality of preforms (1) is produced from the metal band (5).

3. Method according to one of the preceding claims, characterized in that a metal band (5) made of copper is used.

4. Method according to one of the preceding claims, characterized in that a silver hard solder is applied to produce the hard solder layer (3).

## Revendications

1. Procédé de préparation de pièces conformées (1) revêtues de brasure dure, destinées à la réparation d'interruptions de pistes conductrices, notamment à la réparation de pistes conductrices en méandres, caractérisé en ce qu'il consiste,
- à dégager d'abord, par gravure, les pièces conformées (1) dans une bande métallique (5), et ensuite
- à déposer la couche de brasure dure (3) par pulvérisation cathodique.

2. Procédé suivant la revendication 1, caractérisé, en ce qu'il consiste à fabriquer, à partir de la bande métallique (5), un flan 2 de pièces conformées comportant plusieurs pièces conformées (1).

3. Procédé suivant l'une des revendications précédentes, caractérisé, en ce qu'il consiste à utiliser une bande métallique (5) en cuivre.

4. Procédé suivant l'une des revendications précédentes, caractérisé, en ce qu'il consiste, pour obtenir la couche de brasure dure (3), à déposer une couche de brasure d'argent.

# FIG 1

# FIG 2

# FIG 3